(19) Europäisches Patentamt
European Patent Office
Office européen des brevets

(11) **EP 2 577 706 B1**

(12) **FASCICULE DE BREVET EUROPEEN**

(45) Date de publication et mention
de la délivrance du brevet:
**23.07.2014 Bulletin 2014/30**

(21) Numéro de dépôt: **11723542.4**

(22) Date de dépôt: **29.04.2011**

(51) Int Cl.:
*H01J 37/244* *(2006.01)*    *H01J 37/256* *(2006.01)*
*H01J 37/26* *(2006.01)*    *H01J 37/22* *(2006.01)*
*H01J 37/02* *(2006.01)*

(86) Numéro de dépôt international:
**PCT/FR2011/050986**

(87) Numéro de publication internationale:
**WO 2011/148072 (01.12.2011 Gazette 2011/48)**

(54) **SYSTEME DE DETECTION DE CATHODOLUMINESCENCE SOUPLE ET MICROSCOPE METTANT EN OEUVRE UN TEL SYSTEME**

DETEKTIONSSYSTEM MIT FLEXIBLER KATHODOLUMINESZENZ UND MIKROSKOP MIT SOLCH EINEM SYSTEM

FLEXIBLE CATHODOLUMINESCENCE DETECTION SYSTEM AND MICROSCOPE EMPLOYING SUCH A SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.05.2010 FR 1054109**

(43) Date de publication de la demande:
**10.04.2013 Bulletin 2013/15**

(73) Titulaires:
• **Centre National de la Recherche Scientifique**
**75016 Paris (FR)**
• **Université Paris-Sud 11 (Paris XI)**
**91400 Orsay (FR)**

(72) Inventeurs:
• **KOCIAK, Mathieu**
**F-91120 Palaiseau (FR)**
• **ZAGONEL, Luiz, Fernando**
**CEP-13084-791 Campinas (BR)**
• **TENCE, Marcel**
**F-92130 Issy les Moulineaux (FR)**
• **MAZZUCCO, Stefano**
**Cambridge CB4 1GF (GB)**

(74) Mandataire: **Pontet Allano & Associes**
**Parc Les Algorithmes, Bâtiment Platon**
**CS 70003 Saint Aubin**
**91192 Gif sur Yvette Cedex (FR)**

(56) Documents cités:
EP-A1- 1 956 632    EP-A2- 1 739 715
JP-A- 2003 157 789    US-A- 5 013 915
US-A1- 2003 053 048    US-A1- 2008 315 093

EP 2 577 706 B1

**Description**

La présente invention concerne un système de détection de cathodoluminescence. Elle concerne également un microscope mettant en oeuvre un tel système.

Le domaine de l'invention est le domaine de la cathodoluminescence et plus particulièrement le domaine des systèmes utilisant des particules chargées tels que des microscopes à particules chargées, par exemple les microscopes utilisant le principe de la cathodoluminescence.

On connaît actuellement de nombreux systèmes de détection de cathodoluminescence couplés à des microscopes à particules chargées, tels que des microscopes électroniques à transmission (MET) ou à balayage (METB).

L'effet physique utilisé dans ces microscopes, appelé cathodoluminescence, est basé sur la détection de signaux optiques, émis du fait d'une excitation par un faisceau de particules chargées. Les microscopes utilisés sont dotés d'un canon de particules chargées produisant un faisceau de particules chargées qui est envoyé sur un échantillon étudié. L'échantillon frappé par ce faisceau de particules est excité et émet à son tour un rayonnement lumineux. Le rayonnement lumineux est collecté par une optique de collection dont le rôle est de diriger ce rayonnement lumineux vers des moyens d'analyse de ce rayonnement lumineux. Des moyens dits d'adaptation peuvent être disposés entre l'optique de collection et les moyens d'analyse pour adapter et transporter le rayonnement lumineux à l'entrée des moyens d'analyse. Un tel microscope est décrit dans le brevet US 7,589,322.

On connait le document US 2003/053048 A1 qui divulgue un système de détection de cathodoluminescence comprenant une optique de collection collectant le rayonnement lumineux provenant d'un échantillon disposé dans une chambre à vide. Ce système comprend en outre un tube intérieur disposé dans un élément extérieur se présentant sous la forme d'un tube extérieur. Une fenêtre d'étanchéité est disposée sur l'extrémité avale du tube extérieur en aval du tube intérieur de sorte que la pression qui règne dans le tube extérieur et dans le tube intérieur est égale à la pression de la chambre à vide du système de cathodoluminescence. Le système comprend en outre des moyens de traitement optique du rayonnement lumineux collecté, disposés dans un système d'analyse en dehors du tube intérieur et du tube extérieur.

Cependant, les systèmes de détection de cathodoluminescence actuellement connus ne sont pas souples. En effet, l'optique de collection et les moyens d'adaptation se trouvent dans une chambre où règne une pression réduite, chambre de vide. Il n'est pas possible de réaliser une opération de maintenance sur ces éléments sans ouvrir la colonne du microscope. Par exemple, lorsqu'une opération de maintenance est nécessaire sur les moyens d'adaptation, la mise à l'air du microscope et la remise sous vide sont longues, et l'accès aux moyens d'adaptation est délicat. Par ailleurs, ces microscopes sont des machines qui sont très sensibles et nécessitent des réglages très précis, ce qui complique encore plus les opérations de maintenance.

Par ailleurs, il n'est pas non plus possible de réaliser un changement d'un composant sur ces systèmes de cathodoluminescence pour adapter leur utilisation à une application bien particulière. Toute modification nécessite une fois encore l'intervention du fabriquant ou d'un technicien.

Un but de la présente invention est de remédier aux inconvénients précités.

Un autre but de la présente invention est de proposer un système de détection de cathodoluminescence dont la maintenance est plus facile à réaliser et moins coûteuse.

En outre, un autre but de l'invention est de proposer un système de détection de cathodoluminescence plus souple et pouvant être modifié facilement en fonction des applications.

Selon un aspect de l'invention, au moins l'un de ces buts est atteint par un système de détection de cathodoluminescence selon la revendication 1.

Dans la présente demande, les termes « amont » et « aval » sont définis par rapport et dans le sens du trajet du rayonnement lumineux, c'est-à-dire le sens allant de la source d'émission de particules chargées vers l'échantillon, puis vers l'optique de collection et enfin vers les moyens d'analyse du rayonnement lumineux.

L'optique de collection est définie comme étant l'ensemble des éléments réalisant la collecte du rayonnement lumineux émanant de l'échantillon et renvoyant ce rayonnement lumineux vers les moyens d'analyse.

Ainsi, le système de détection de cathodoluminescence est plus souple et peut être modifié facilement en fonction des applications. En effet, les moyens d'adaptation, ne se trouvant pas dans la chambre à vide, peuvent être échangés ou remplacés plus facilement en fonction des applications. Il est par ailleurs possible d'ajouter des éléments permettant de traiter le rayonnement lumineux, tel que par exemple un polariseur, avant que le rayonnement lumineux n'entre dans les moyens d'analyse.

Par ailleurs, la maintenance du système de détection de cathodoluminescence selon l'invention est plus facile et moins coûteuse à réaliser que pour les systèmes de l'état de la technique. En effet, les moyens d'adaptation étant plus facilement accessibles, ils peuvent être changés plus facilement en cas de mauvais fonctionnement.

Le système selon l'invention comprend avantageusement des moyens d'étanchéité disposés entre l'optique de collection et les moyens d'adaptation et qui sont prévus pour assurer l'étanchéité de ladite chambre tout en autorisant le passage du rayonnement lumineux. De tels moyens d'étanchéité peuvent par exemple comprendre une fenêtre réalisée en une matière transparente n'influant pas sur le rayonnement lumineux et résistante à la différence de pression existante entre la chambre à vide et l'environnement dans lequel se trouvent les moyens d'adaptation, par exemple l'environnement atmosphérique.

Les moyens d'adaptation peuvent comprendre au moins une lentille disposée en amont d'une fibre optique et prévue pour adapter la taille du rayonnement lumineux à l'entrée de la fibre optique, et plus particulièrement la taille du faisceau lumineux au diamètre de la fibre optique et l'angle d'incidence à l'ouverture numérique de la fibre optique. La fibre optique a pour rôle de transporter le rayonnement lumineux jusqu'aux moyens d'analyse.

Dans un mode de réalisation particulier, l'optique de collection peut comprendre un miroir parabolique renvoyant le rayonnement lumineux, par exemple de manière collimatée. Dans ce cas, le miroir parabolique peut comprendre une ouverture traversante disposée en regard de la source d'émission de particules chargées et laissant passer le faisceau de particules chargées vers l'échantillon.

Dans un deuxième mode de réalisation particulier, l'optique de collection peut comprendre un miroir plan. Ce miroir plan peut être associé à une lentille collectrice disposée en aval dudit miroir plan et renvoyant le rayonnement lumineux, par exemple de manière collimatée. Dans ce cas, le miroir plan peut comprendre une ouverture traversante disposée en regard de la source d'émission de particules chargées et laissant passer le faisceau de particules chargées vers l'échantillon.

Dans un troisième mode de réalisation particulier, l'optique de collection peut comprendre un miroir elliptique, éventuellement associé à une lentille collectrice disposée en aval du miroir elliptique.

Plus généralement, l'optique de collection peut comprendre un miroir concave.

Selon l'invention, le système comprend un tube en forme de cylindre, dit cylindre extérieur, dont l'axe est aligné par rapport à l'axe de l'optique de collection et rigidement fixé à ladite optique de collection, ledit cylindre extérieur comprenant une fenêtre d'étanchéité assurant le maintien de la pression de la chambre dans laquelle est disposée ladite optique de collection. La fenêtre d'étanchéité est réalisée en un matériau :

- autorisant le passage du rayonnement lumineux provenant de l'optique de collection, et
- assurant l'étanchéité de la chambre à vide.

Ainsi, à l'intérieur du cylindre extérieur et en aval de la fenêtre d'étanchéité règne une pression supérieure à la pression de la chambre à vide, par exemple une pression atmosphérique. Cette partie du cylindre extérieur est plus facilement accessible par un opérateur que l'intérieur de la chambre à vide.

Toujours selon l'invention, le système comprend en outre un tube en forme de cylindre, dit cylindre intérieur, disposé centré dans le cylindre extérieur et prévu pour recevoir les moyens d'adaptation du rayonnement lumineux en vue d'injecter ledit rayonnement lumineux dans une fibre optique ou dans un moyen d'analyse tel qu'un photomultiplicateur, une caméra, un spectromètre muni d'une caméra ou d'un photomultiplicateur.

Les moyens optiques d'adaptation peuvent comprendre un ensemble de lentilles et ou de miroirs permettant d'adapter la taille du rayonnement optique au contraintes spatiales imposées par les parois du tube afin de conserver l'intensité jusqu'au détecteur final. Les différents éléments de l'optique d'adaptation posséderont des ouvertures numériques adaptées les unes par rapport aux autres et par rapport aux systèmes de détection ou de la fibre optique, afin là encore de préserver l'intensité le long du parcours du rayonnement optique. Dans le cas où une fibre optique est utilisée avant le détecteur, son ouverture numérique sera adaptée audit système de détecteur.

Le cylindre intérieur peut en outre comporter tout élément optique utilisé pour les besoins de l'expérimentation, par exemple un polariseur ou un filtre.

Avantageusement, le cylindre intérieur peut être monté démontable dans le cylindre extérieur. Ainsi, il est possible de l'extraire du cylindre extérieur pour intervenir sur les éléments se trouvant à l'intérieur.

Le cylindre intérieur peut être également monté libre en rotation par rapport audit cylindre extérieur. Ainsi, il est possible de modifier facilement et rapidement l'orientation des éléments se trouvant dans le cylindre intérieur sans avoir à démonter le cylindre intérieur ou l'élément optique se trouvant à l'intérieur du cylindre intérieur. Une telle configuration est particulièrement avantageuse dans le cas où le cylindre intérieur comprend au moins un élément optique dont l'orientation est importante sur le traitement du rayonnement lumineux, par exemple un polariseur.

De plus, le tube intérieur est automatiquement centré sur le tube extérieur et donc sur l'axe optique. Ceci permet de changer de tube sans se désaligner, rendant le changement de tubes intérieurs rapide, robuste et reproductible.

Le système selon l'invention peut en outre comprendre des moyens d'analyse de rayonnement lumineux disposés en aval des moyens d'adaptation.

Avantageusement, les éléments se trouvant dans le cylindre intérieur sont placés au plus près de l'optique de collection pour réduire les effets d'un possible désalignement léger entre l'axe optique de l'optique de collection et le centre du cylindre intérieur.

Par ailleurs, ledit cylindre extérieur a un diamètre interne suffisamment grand pour permettre l'utilisation des éléments optiques, tels que des lentilles, ou des détecteurs tels que des photomultiplicateurs et des caméras CCD, à l'intérieur du cylindre extérieur.

Avantageusement, l'optique de collection peut avoir une surface conductrice isolée électriquement par rapport au reste du dispositif et du microscope. L'optique de collection peut ainsi être mise à un potentiel électrique faible par rapport à la masse du microscope, éventuellement via un fil électrique accessible de l'extérieur du microscope via un passage électrique étanche, pour pouvoir ainsi détecter, par l'apparition d'un courant électrique, un contact quelconque avec le microscope. En effet, l'optique de collection se trouve dans un espace encombré et ne doit pas s'écraser contre les éléments standard du microscope, tels que l'échantillon ou la pièce polaire. Ces mouvements doivent être surveillés avec attention. En mesurant le courant électrique entre l'optique de collection et le microscope, il est possible de déterminer l'occurrence d'un contact léger entre l'optique de collection et le microscope.

Les moyens d'analyse peuvent comprendre de manière non exhaustive une caméra CCD et/ou un photomultiplicateur précédés ou non d'un spectromètre.

Dans un mode de réalisation particulier, la fibre optique et reliée directement aux moyens d'analyse.

Dans un mode de réalisation particulier, la fibre optique peut être remplacée par un ensemble de fibres accolées et reliées directement aux moyens d'analyse.

Dans un mode de réalisation particulier, les fibres accolées sont disposées selon un disque en amont, et suivant une ligne en aval. La disposition en disque permet de recueillir le signal même en cas de décentrage léger, la disposition en ligne permet d'optimiser l'intensité et la résolution spectrale lorsque l'ensemble de fibres est placé en entrée d'un spectromètre optique par exemple.

Avantageusement, les moyens d'adaptation peuvent comprendre un diaphragme arrangé pour laisser passer le rayonnement lumineux provenant de l'optique de collection vers les moyens d'analyse et bloquer au moins un signal optique indésirable. En effet, dans un mode de réalisation particulier, un diaphragme peut être placé centré le long de l'axe optique permettant de laisser passer les rayonnements lumineux émis à l'entourage du point focal de l'optique de collection (sur l'échantillon) et permettant de filtrer les rayonnements lumineux émis à partir d'autres régions de l'échantillon.

En effet, le faisceau de particules chargées en frappant l'échantillon peut éjecter différentes particules comme des électrons et des ions dit secondaires et de particules chargées dites rétrodiffusées. Ces particules secondaires et rétrodiffusées peuvent à leur tour frapper différents objets à l'intérieur du microscope (et loin du point focal de l'optique de collection) et causer l'émission de rayonnement lumineux non pertinent, que l'on filtrera donc avec un diaphragme.

Avantageusement, les fibres accolées, disposées selon un disque en amont, ont un diamètre réduit déterminé pour faire office de diaphragme.

Avantageusement, l'optique collection peut être montée déplaçable sur au moins une dimension, le système selon l'invention comprenant en outre des moyens de positionnement prévus pour déplacer ladite optique de collection selon au moins une dimension. Ainsi, le système selon l'invention est encore plus souple et est positionnable, permettant ainsi d'améliorer la brillance et la résolution spatiale du signal obtenu.

Avantageusement, les moyens de positionnement de l'optique collection peuvent comprendre des moyens de translation de ladite optique de collection sur au moins une dimension.

Les moyens de positionnement de l'optique collection peuvent en outre comprendre des moyens de rotation de ladite optique de collection autour d'au moins un axe de rotation.

Les moyens de positionnement peuvent comprendre une platine montée déplaçable sur au moins une dimension, l'optique de collection étant montée solidaire de ladite platine, ledit système comprenant en outre au moins un élément de positionnement, par exemple une vis micrométrique, un actuateur piézoélectrique ou capacitif, chaque élément de positionnement étant prévu pour déplacer ladite platine selon au moins une dimension.

Dans un mode de réalisation particulier du système de détection de cathodoluminescence selon l'invention, l'optique de collection est montée solidaire à l'extrémité proximale du cylindre extérieur de manière bien centrée et coaxiale à l'axe optique de l'optique de collection. Le cylindre extérieur comporte du côté de son extrémité proximale une fenêtre d'étanchéité transparente et agencée pour préserver l'étanchéité de la chambre à vide. Le cylindre intérieur est inséré dans le cylindre extérieur de manière démontable et libre en rotation. Ce dernier est monté coaxial avec le cylindre extérieur et est donc forcément centré par rapport à l'axe optique de l'optique collection à tout moment. Les moyens d'adaptation, ainsi que l'entrée de la fibre optique sont disposés dans le cylindre intérieur et se trouvent donc à une pression atmosphérique. Ces éléments sont facilement accessibles par un opérateur puisque le cylindre intérieur est démontable. Le cylindre intérieur peut en outre comprendre tout élément optique tel que par exemple un polariseur.

Le cylindre extérieur est entouré d'au moins un moyen d'étanchéité autorisant le déplacement du cylindre extérieur dans les trois directions de l'espace tout en préservant l'étanchéité de la chambre à vide dans laquelle se trouve l'optique de collection. Un tel moyen d'étanchéité peut par exemple comprendre un soufflet étanche autorisant le déplacement du cylindre dans les trois directions et monté sur une paroi de la chambre à vide autour ou au niveau d'une ouverture réalisée dans cette paroi dans la direction suivie par le rayonnement lumineux renvoyé par l'optique de collection vers les moyens d'analyse.

Le cylindre extérieur est monté solidairement sur une platine. Cette platine est déplaçable dans les trois directions de l'espace grâce à des vis micrométriques. Ainsi en déplaçant la platine l'opérateur peut déplacer le cylindre extérieur et l'optique de collection.

Lors du déplacement de l'ensemble platine, cylindre extérieur et optique de collection, l'étanchéité de la chambre à vide est conservée grâce au soufflet entourant le cylindre extérieur et fixé à la paroi de la chambre à vide, et à la fenêtre d'étanchéité disposée dans le cylindre extérieur.

L'optique de collection est solidaire du cylindre extérieur. Ce dernier est centré par rapport à l'axe optique de l'optique de collection. Le cylindre intérieur est centré par rapport au cylindre extérieur. Ainsi tous les éléments se trouvant dans le cylindre intérieur sont centrés par rapport à l'axe optique de l'optique de collection. L'ensemble optique de collection+cylindre extérieur+cylindre intérieur étant solidaire, ces derniers restent toujours bien centrés à tout moment.

Avantageusement, le système selon l'invention peut comprendre une source d'émission d'un faisceau lumineux se propageant dans le sens inverse du sens de propagation du rayonnement lumineux détecté en provenance de l'échantillon et reçu par l'optique de collection, ledit faisceau lumineux étant dirigé vers l'échantillon par l'optique de collection.

En effet, le système de cathodoluminescence peut en outre être utilisé pour injecter de la lumière sur l'échantillon. Dans ce cas, le système de cathodoluminescence comprend une source d'émission d'un faisceau lumineux à la place ou en plus du système de détection. Cette source est alors arrangée pour émettre un faisceau lumineux dans le sens inverse du sens de propagation du rayonnement lumineux détecté, c'est-à-dire de l'aval vers l'amont. La source de lumière est focalisée sur l'échantillon, les zones d'exposition aux particules chargées et au faisceau lumineux étant superposées. La source de lumière peut être une source de lumière spatialement cohérente, par exemple un laser, de sorte que la taille du faisceau lumineux frappant l'échantillon n'est limitée que par les lois de l'optique géométrique et de la diffraction pour ainsi optimiser la densité de puissance reçue par l'échantillon.

Avantageusement, le système selon l'invention peut en outre être utilisé avec un séparateur de rayonnement lumineux et être utilisé pour injecter de la lumière sur l'échantillon et en même temps collecter la lumière émise par l'échantillon.

En effet, le système de cathodoluminescence peut en outre être utilisé pour détecter le rayonnement lumineux émis par l'échantillon par l'effet de photoluminescence, c'est-à-dire quand un faisceau lumineux frappe un objet, ce qui le pousse à émettre à son tour un rayonnement lumineux. Ce séparateur est alors arrangé pour permettre l'injection d'un faisceau lumineux de l'aval vers l'amont et la détection simultanée de rayonnement lumineux de l'amont vers l'aval. La petite taille du faisceau injecté peut permettre l'excitation d'une petite partie de l'échantillon qui peut être en même temps imagée avec le faisceau de particules chargées du microscope. Le rayonnement lumineux émis par l'échantillon lors de l'injection de lumière peut être analysé de la même façon que le rayonnement lumineux émis suite à l'interaction de particules chargées.

Selon un autre exemple de l'invention, il est proposé un système de cathodoluminescence permettant de collecter le rayonnement lumineux issu de l'échantillon éclairé par un faisceau de particules chargées de taille nanométrique ou sub-nanométrique éventuellement balayé à la surface de l'échantillon et de le transporter jusqu'aux moyens d'analyse tout en conservant plus d'intensité lumineuse et de résolution spectrale comparé aux systèmes de cathodoluminescence de l'état de la technique.

Selon cet exemple l'invention un tel système de cathodoluminescence comprend :

- une source de particules chargées agencée pour éclairer un échantillon avec un faisceau de particules chargées, et
- un chemin optique comprenant au moins deux éléments optiques prévus pour collecter et transporter un rayonnement lumineux provenant dudit échantillon éclairé vers des moyens d'analyse ;

ledit système étant caractérisé en ce que chaque élément optique dudit chemin optique est choisi de sorte que :

- l'angle maximal de sortie dudit élément optique soit inférieur ou égal à 120% de l'angle maximal d'acceptance de l'élément optique suivant ; et
- le diamètre du rayonnement provenant dudit élément optique dans le plan d'entrée de l'élément optique suivant soit inférieur ou égal à 120% du diamètre utile d'entrée de l'élément optique suivant.

Ainsi, selon cet exemple de l'invention chaque élément transmet au moins 60% du signal lumineux. Seule une perte de 20% du signal lumineux a lieu au niveau de chaque élément optique du chemin optique.

Un tel système de cathodoluminescence permet de collecter le rayonnement lumineux issu de l'échantillon éclairé et de le transporter jusqu'aux moyens d'analyse tout en conservant plus d'intensité lumineuse comparé aux systèmes de cathodoluminescence de l'état de la technique.

Selon une version préférée du système de l'invention, chaque élément optique du chemin optique est choisi de sorte que l'angle maximal de sortie d'un élément optique soit inférieur ou égal à l'angle maximal d'acceptance de l'élément optique suivant. Ainsi, l'angle de sortie d'un élément optique est adapté et le rayonnement lumineux sortant d'un élément optique arrive à l'élément optique suivant avec un angle tel que la totalité du rayonnement lumineux entre dans l'élément optique suivant.

Toujours selon une version préférée du système selon l'invention, chaque élément optique du chemin optique est choisi de sorte que le diamètre du rayonnement provenant d'un élément optique dans le plan d'entrée de l'élément optique suivant soit inférieur ou égal au diamètre utile d'entrée de l'élément optique suivant. Ainsi, le rayonnement lumineux arrivant à l'élément optique suivant entre totalement dans l'élément optique suivant.

Dans la combinaison de ces deux versions préférées du système selon l'invention, cette version préférée de l'invention, le signal lumineux est transmis d'un élément optique à l'autre sans aucune perte d'intensité autre que celle due à l'absorption ou la diffusion des systèmes optiques et la totalité de cette intensité du signal lumineux est conservée sur l'ensemble du chemin optique.

Avantageusement, lorsque le chemin optique comprend N éléments optiques, chaque élément optique du chemin optique peut être positionné de sorte que le décalage d'un élément optique par rapport au centre de l'élément optique précédent vérifie la relation suivante :

$$Ds_i/2 \leq 1.2 De_{i+1}/2 - \Delta_{i+1} \quad pour\ i=1...N\text{-}1$$

avec :

- $\Delta_{i+1}$ le décalage de l'élément optique i+1 par rapport au centre de l'élément optique i,
- $De_{i+1}$ le diamètre utile d'entrée de l'élément i+1,
- $D_{Si}$ le diamètre du rayonnement provenant de l'élément i mesuré à l'entrée de l'élément i+1.

Un tel système permet de s'assurer un positionnement amélioré par rapport aux systèmes de l'état de la technique et ainsi de véhiculer le rayonnement lumineux sur l'ensemble du chemin optique avec peu de perte.

Dans une version préférée du système selon l'invention, chaque élément optique du chemin optique peut être positionné de sorte que le décalage d'un élément optique par rapport au centre de l'élément optique précédent vérifie la relation suivante :

$$Ds_i/2 \leq De_{i+1}/2 - \Delta_{i+1} \quad pour\ i=1...N\text{-}1$$

avec :

- $A_{i+1}$ le décalage de l'élément optique i+1 par rapport au centre de l'élément optique i,
- $De_{i+1}$ le diamètre utile d'entrée,
- $D_{Si}$ le diamètre de du faisceau provenant de l'élément i mesuré à l'entrée de l'élément i+1.

Un tel système permet d'obtenir un positionnement des éléments optiques tel que tout le rayonnement sortant d'un élément optique entre dans l'élément optique suivant sans perte autre que celles induites par absorption ou diffusion car aucun élément optique ne présente un décalage par rapport à l'élément optique précédent tel qu'une partie du rayonnement soit perdue.

Selon l'invention, un des éléments optiques du chemin optique peut être un spectromètre, et plus particulièrement un spectromètre comprenant un élément focalisant à son entrée.

Dans ce cas, le spectromètre et les autres éléments optiques du chemin optique peuvent être choisis de sorte que la largeur du faisceau à l'entrée du spectromètre suivant la direction dispersive soit inférieure ou égale à 10 fois le diamètre limite à l'entrée du spectromètre en dessous duquel la résolution du spectromètre ne dépend plus du diamètre de la taille du rayonnement lumineux à l'entrée du spectromètre. La valeur d'un tel diamètre limite est une donnée fournie par le constructeur du spectromètre et dépend en grande partie de son grandissement suivant la direction dispersive.

Ainsi, le système selon l'invention permet de véhiculer le rayonnement lumineux jusqu'au spectromètre sans perte d'intensité, car les diamètres et les angles sont adaptés, tout en assurant la résolution spectrale optimale pour un spectromètre donné.

Toujours dans le cas où un des éléments du chemin otique est un spectromètre, le spectromètre et les autres éléments optiques du chemin optique peuvent préférentiellement être choisis de sorte que la largeur du faisceau à l'entrée du spectromètre dans la direction dispersive soit inférieure ou égale au diamètre limite à l'entrée du spectromètre en dessous duquel la résolution du spectromètre ne dépend plus du diamètre de la taille du rayonnement lumineux à l'entrée du spectromètre.

Ainsi, le système selon l'invention permet de véhiculer le rayonnement lumineux jusqu'au spectromètre sans perte d'intensité, car les diamètres et les angles sont adaptés, tout en assurant une résolution spectrale optimale pour un spectromètre donné.

Dans un mode de réalisation particulier, l'élément optique précédent le spectromètre peut comprendre une fibre optique dont la sortie est positionnée ou imagée à l'entrée du spectromètre.

Dans ce cas, la fibre optique et l'élément optique précédant la fibre optique peuvent être choisis de sorte que :

- le diamètre du faisceau provenant de l'élément optique précédent mesuré à l'entrée de la fibre soit inférieur ou égal à 120 %, préférentiellement inférieur ou égal à 100%, du diamètre utile de la fibre optique, et
- l'angle d'entrée maximum du faisceau provenant de l'élément optique précédent soit inférieur ou égal à 120 %, préférentiellement inférieur ou égal à 100%, de l'angle limite d'incidence de ladite fibre optique.

Ainsi, le chemin optique est parfaitement adapté pour que l'ensemble du rayonnement lumineux entre dans la fibre optique dans des conditions telles que l'ensemble du rayonnement optique est transporté jusqu'au spectromètre sans perte ou avec des pertes négligeables.

Dans une version particulièrement avantageuse et préférée de l'invention, l'élément optique précédant le spectromètre peut comprendre une pluralité de fibres optiques composant un faisceau de fibres optiques, les fibres dudit faisceau étant alignées, du côté dudit spectromètre, perpendiculairement à l'axe de dispersion dans le plan d'entrée dudit spectromètre, la somme des diamètres de l'ensemble des fibres est préférentiellement inférieure ou égale à la taille du détecteur suivant la direction non dispersive divisée par le grandissement du spectromètre suivant la direction non dispersive. Chaque fibre optique composant le faisceau de fibres optiques est choisie, de sorte que :

- le diamètre du faisceau provenant de l'élément optique précédent à l'entrée de la fibre soit inférieur ou égal à 120 %, préférentiellement à 100%, du diamètre utile de la fibre optique, et
- l'angle d'entrée maximum du faisceau provenant de l'élément optique précédent soit inférieur ou égal à 120 %, préférentiellement à 100%, de l'angle limite d'incidence de ladite fibre optique.

Ainsi, cette construction permet de s'assurer que quel que soit le décalage du dernier élément optique selon n'importe quel axe de l'espace, au moins une fibre optique est positionnée pour recevoir la totalité du rayonnement, ou presque la totalité du rayonnement. De plus, le faisceau de fibres étant orienté perpendiculairement à la direction non dispersive du spectromètre, la résolution spectrale sera dépendante de la largeur des fibres et non du diamètre du faisceau, bien que l'intensité collectée dépende de la somme des aires des fibres illuminées. Un tel système est particulièrement efficace pour corriger les erreurs, dites dynamiques, dues à des désalignements causés par exemple par un balayage du faisceau de particules chargées sur l'échantillon ou des erreurs d'alignements systématiques.

Dans un exemple de réalisation particulier, le faisceau de fibres peut être compact et préférentiellement hexagonal en entrée.

Le diamètre de chacune des fibres du faisceau de fibres peut être identique.

Par ailleurs, dans une version préférée mais non limitative, le rapport entre le diamètre total du faisceau de fibres et le diamètre d'une fibre peut être compris entre 3 et 30.

Avantageusement, le premier élément optique peut comprendre un élément de collection qui peut être soit un miroir courbe soit un miroir plan associé à une lentille pour collecter le rayonnement lumineux provenant de l'échantillon. Pour s'insérer dans la pièce polaire du microscope dans le lequel est inséré le système de cathodoluminescence et permettant de former le faisceau de particules chargées, et sachant que l'espace dans ces pièces polaires est d'autant plus faible que la résolution spatiale désirée est meilleure, cet élément de collection présente avantageusement une épaisseur totale comprise entre 0.5 et 10 mm, et préférentiellement comprise entre 1 et 8 mm, pour permettre une collection du rayonnement lumineux provenant de l'échantillon selon un angle solide le plus grand possible.

Pour améliorer la collection du rayonnement lumineux provenant de l'échantillon, le premier élément optique réalisant la collection du rayonnement lumineux peut avantageusement présenter :

- un paramètre « p » compris entre 0.5 et 20 mm, plus préférentiellement entre 1 et 7 mm, et encore plus préférentiellement entre 1.5 et 5 mm, encore plus préférentiellement entre 1 et 3 mm, ou encore un paramètre « p » de l'ordre de 2 mm à ±1.5 mm ; ou
- une focale « f » comprise entre 0.25 et 10 mm, plus préférentiellement entre 0.5 et 3.5 mm, et encore plus préférentiellement entre 0.75 et 2.5 mm.

Selon un mode de réalisation avantageux, les éléments optiques du chemin optique peuvent être positionnés de sorte que la précision du déplacement dans au moins une des deux directions de l'espace perpendiculaires à l'axe optique soit meilleure ou égale :

- à la taille à l'entrée du spectromètre, c'est-à-dire la dimension du pixel du détecteur divisé par le grandissement du spectromètre, divisé par le grandissement total réalisé sur le chemin optique entre la source et l'entrée du spectromètre, ou
- lorsque l'élément optique précédant le spectromètre est une fibre ou un faisceau de fibres optiques, au diamètre de la fibre optique, ou de la plus grande des fibres dans le faisceau, divisé par le grandissement total réalisé sur le chemin optique jusqu'à l'entrée de la fibre optique ou du faisceau de fibres optiques.

Dans un tel système, la précision de l'alignement dans le plan perpendiculaire à l'axe optique est telle que les désalignements résiduels ne diminuent essentiellement pas les performances décrites (conservation de l'intensité collectée jusqu'au détecteur, résolution spectrale optimale).

Avantageusement, les éléments optiques du chemin optique peuvent en outre être positionnés de sorte que la précision dans la direction de l'axe optique est supérieure ou égale :

- à la taille de l'entrée du spectromètre, c'est-à-dire la dimension du pixel du détecteur divisé par le grandissement du spectromètre, divisée par le grandissement réalisé sur le chemin optique entre la source et le plan d'entrée du spectromètre et par l'angle maximal d'acceptance du premier élément optique, ou
- lorsque le dernier élément optique est une fibre ou un faisceau de fibres optiques, au diamètre de la fibre optique, ou le diamètre de la plus grande fibre dans le faisceau, divisé par le grandissement réalisé sur le chemin optique entre la source et le plan d'entrée de la fibre optique ou du faisceau de fibres et par l'angle maximal d'acceptance du premier élément optique.

Dans un tel système, la précision de l'alignement le long de l'axe optique est telle que les désalignements résiduels ne diminuent essentiellement pas les performances décrites : conservation de l'intensité collectée jusqu'au détecteur, résolution spectrale optimale, etc.

Dans le système selon l'invention, le chemin optique comprend au moins deux éléments optiques, au moins un premier élément optique, dit optique de collection, pour collecter un rayonnement lumineux provenant de l'échantillon éclairé et au moins un deuxième élément optique, dit optique d'adaptation, pour transporter le rayonnement collecté vers des moyens d'analyse.

Ce système peut en outre comprendre des moyens de translation, pour translater l'optique de collection linéairement et indépendamment selon trois axes différents de l'espace. Ainsi, le déplacement de l'optique de collection est réalisé selon chaque axe indépendamment des autres axes. Par ailleurs, le déplacement sur chaque axe est une translation.

Dans une version particulière du système selon l'invention, tout ou partie de l'optique d'adaptation peut être disposée dans un environnement où règne une pression supérieure à la pression dans une chambre à vide dans laquelle est disposée l'optique de collection.

Bien entendu les deux aspects de la présente invention présentés ci-dessus sont indépendants l'un de l'autre mais peuvent être combinés sur un unique système de cathodoluminescence. L'invention concerne également un tel système de cathodoluminescence combinant les deux aspects décrits dans la présente demande.

Selon un exemple de l'invention, il est proposé en outre un microscope comprenant :

- une source d'émission d'un faisceau de particules chargées, et
- un système de détection de cathodoluminescence selon l'invention.

Avantageusement, le microscope peut en outre comprendre en outre au moins :

- un détecteur fond clair,
- un détecteur fond noir,
- un détecteur EELS,
- une caméra pour l'imagerie ou la diffraction, ou
- un détecteur EDX.

D'autres avantages et caractéristiques de l'invention apparaîtront à l'examen de la description détaillée d'un mode de mise en oeuvre nullement limitatif, et des dessins annexés sur lesquels :

- la figure 1 est une représentation schématique du principe d'un microscope selon l'invention mettant en oeuvre un système de détection de cathodoluminescence selon l'invention ;

-   la figure 2 est une représentation schématique d'un exemple d'optique de collection mis en oeuvre dans le système de cathodoluminescence selon l'invention ;
-   les figures 3 à 5 sont des représentations schématiques d'un premier aspect du système de détection de cathodoluminescence mis en oeuvre par le microscope de la figure 1 ;
-   les figures 6 et 7 sont des représentations schématiques d'un deuxième aspect du système de détection de cathodoluminescence mis en oeuvre par le microscope de la figure 1 ;
-   la figure 8 est une représentation schématique d'un premier exemple du chemin optique d'un système de cathodoluminescence selon un troisième aspect de l'invention ;
-   la figure 9 est une représentation schématique d'un deuxième exemple du chemin optique d'un système de cathodoluminescence selon le troisième aspect de l'invention comprenant une fibre optique ;
-   les figures 10 et 11 sont des représentations schématiques selon différentes vues d'un troisième exemple du chemin optique d'un système de cathodoluminescence selon le troisième aspect de l'invention comprenant un faisceau de fibres optiques ; et
-   les figures 12 et 13 sont des représentations schématiques de deux configurations dans lesquelles le rayonnement lumineux arrive à l'entrée du faisceau de fibres optiques en deux positions différentes dans le système des figures 10 et 11.

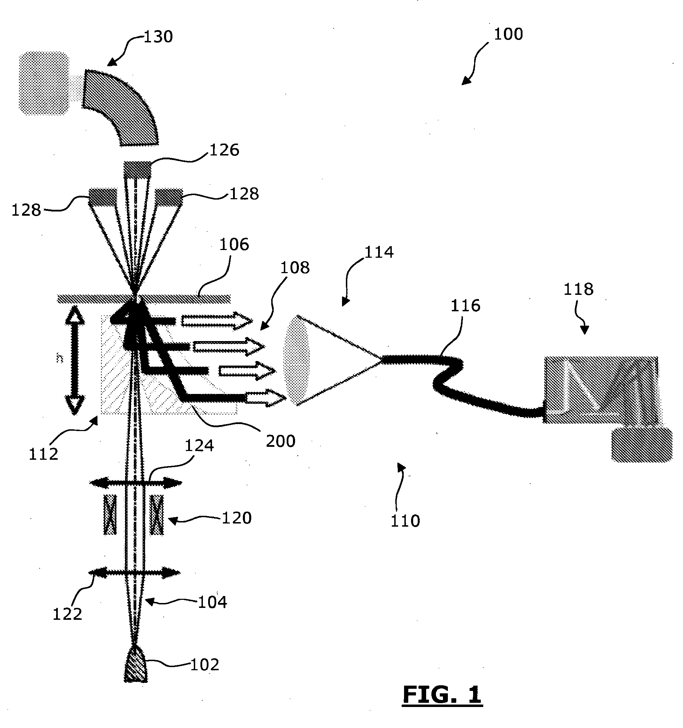

La figure 1 est une représentation schématique du principe du système de détection de cathodoluminescence mis en oeuvre par un microscope 100.

Le microscope 100 comprend une source 102 d'émission d'un faisceau 104 d'électrons sur un échantillon 106. En réponse à ce faisceau d'électrons 104 l'échantillon 106 émet un rayonnement lumineux 108 pouvant comprendre des longueurs d'onde allant de l'infrarouge aux ultraviolets.

Le rayonnement lumineux 108 est ensuite collecté et analysé par un système 110 de détection de cathodoluminescence.

Le système 110 de détection de cathodoluminescence comprend une optique de collection 112, des moyens 114 d'adaptation du diamètre (respectivement de l'angle) du faisceau lumineux 108 au diamètre (respectivement à l'ouverture numérique) d'une fibre optique 116 et des moyens d'analyse 118. L'optique de collection 112 a pour rôle de collecter le rayonnement lumineux 108 émis par l'échantillon 106, la fibre optique 116 a pour rôle de transporter le rayonnement lumineux 108 collecté par l'optique collection 112 jusqu'aux moyens d'analyse 118. Cependant, il est nécessaire d'utiliser des moyens d'adaptation 114 pour adapter le rayonnement lumineux 108 à la sortie de l'optique collection 112 à l'entrée de la fibre optique 116 tout en préservant l'intensité du signal ainsi que sa résolution spectrale.

Les moyens d'analyse 118 peuvent comprendre un spectromètre, une caméra CCD ou un photomultiplicateur prévu pour analyser le rayonnement lumineux 108 transporté par la fibre optique 116.

Le microscope 100 comprend en outre une bobine de balayage 120 disposée entre une lentille condenseur 122 positionnée du côté de la source d'électrons 102 et une lentille objectif 124 positionnée du côté opposé. La bobine de balayage 120 permet de balayer la surface de l'échantillon 106 avec le faisceau d'électrons 104 pour réaliser une étude spectroscopique de l'échantillon 106.

Le microscope peut en outre comprendre un ou plusieurs détecteurs fond clair 126, un ou plusieurs détecteurs fond noir 128 ainsi qu'un détecteur EELS 130.

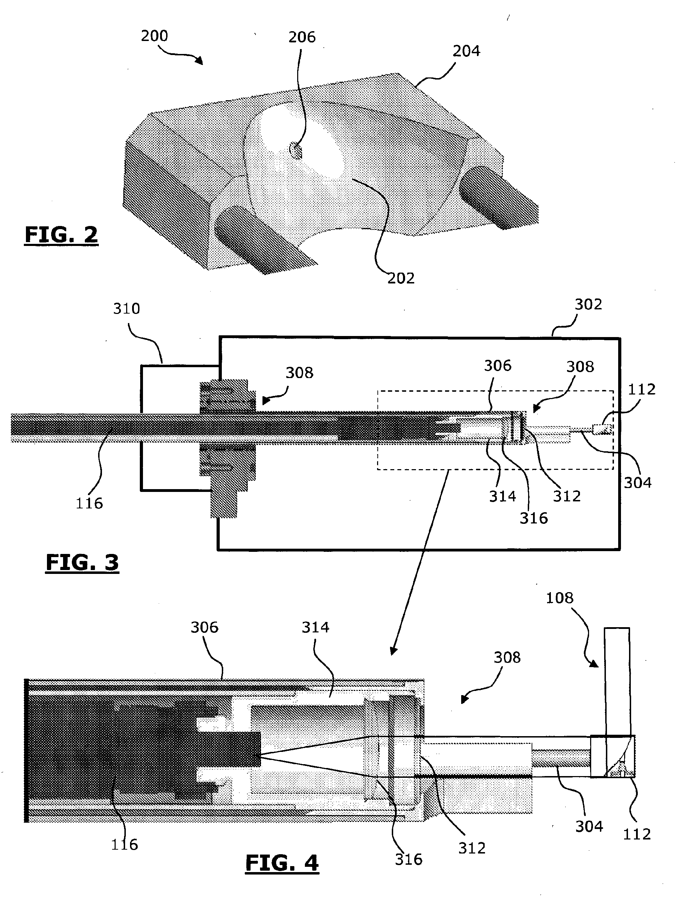

Dans l'exemple représenté sur la figure 1, l'optique de collection 112 comprend un miroir parabolique 200 tel que représenté en figure 2. Le miroir parabolique comprend une surface parabolique 202 réfléchissante taillée dans un bloc 204. Le miroir parabolique 200 comporte une ouverture traversant 206. Cette ouverture 206 est disposée en regard de la source d'émission 102 du faisceau d'électrons 104. Le faisceau d'électrons 104 traverse cette ouverture 206 pour atteindre l'échantillon 106. Le rayonnement lumineux émis par l'échantillon est ensuite collecté par la surface parabolique 202. Le positionnement précis de l'ouverture 206 en face de la source d'émission est très important pour optimiser la brillance et la résolution du rayonnement lumineux collectée par la surface parabolique 204.

Dans un autre exemple de réalisation non représenté, l'optique de collection 112 peut comprendre un miroir plan associé à une lentille collectrice ou un miroir elliptique éventuellement associé à une lentille collectrice à la place du miroir parabolique.

**Premier aspect de l'invention**

Nous allons maintenant décrire un premier aspect du système de cathodoluminescence objet de la présente invention en référence aux figures 3-5.

La figure 3 est une représentation partielle du système de collection par rapport à la chambre à vide d'un microscope.

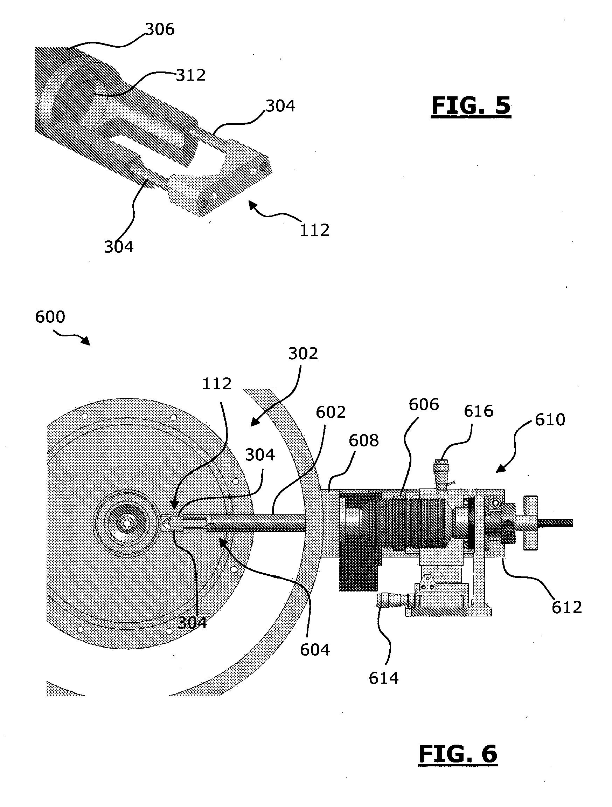

La figure 4 est une représentation plus détaillée en coupe d'une région de la figure 3 et la figure 5 est une représentation selon une vue isométrique de la même région.

Selon ce premier aspect l'optique de collection 112 est prévue pour être disposée dans une chambre à vide 302 du microscope et les moyens d'adaptation 114 ainsi que la fibre optique 116 et les moyens d'analyse 118 sont disposés dans un environnement à la pression atmosphérique. En d'autres termes, les moyens d'adaptation 114, la fibre optique et les moyens d'analyse sont déportés hors de la chambre à vide 302 du microscope.

Pour ce faire, dans l'exemple représenté sur les figures 3 à 5, l'optique de collection 112, qui est un miroir parabolique tel que représenté en figure 2, est reliée solidairement à l'aide de deux vis 304, à un premier cylindre 306, dit cylindre extérieur, au niveau de son extrémité proximale 308. L'optique de collection 112 est reliée au cylindre extérieur de sorte que l'axe optique de l'optique de collection 112 se confond avec l'axe de symétrie du cylindre extérieur 306.

Ce cylindre extérieur 306 pénètre dans la chambre à vide grâce à une ouverture 308 formée dans une paroi de la chambre à vide. Cette ouverture 308 est disposée en regard du rayonnement lumineux renvoyé par l'optique de collection 112.

Le cylindre extérieur 306 et la paroi de la chambre à vide 302 sont maintenus ensemble par un dispositif 310 étanche préservant le niveau de pression qui règne dans la chambre à vide.

Le cylindre extérieur 306 comporte au niveau de son extrémité proximale 308, c'est-à-dire l'extrémité sur laquelle est fixée solidairement l'optique de collection 112, une fenêtre 312 d'étanchéité transparente préservant le niveau de pression qui règne dans la chambre à vide 302 tout en laissant passer le rayonnement lumineux collecté et renvoyé par l'optique de collection 112. Ainsi, en aval de la fenêtre d'étanchéité, l'intérieur du cylindre extérieur 306 est étanchement séparé de la chambre à vide et il y règne une pression atmosphérique.

Un deuxième cylindre 314, dit cylindre intérieur, est disposé à l'intérieur du cylindre extérieur 306 en aval de la fenêtre d'étanchéité 312, c'est-à-dire dans la partie ou règne une pression atmosphérique. Le cylindre intérieur 314 a son axe de symétrie confondu avec l'axe de symétrie du cylindre extérieur 306 et est donc parfaitement aligné avec l'axe optique de l'optique de collection 112. Le cylindre intérieur 314 est disposé dans le cylindre extérieur 306 de manière démontable et libre en rotation.

Les moyens d'adaptation 114 sont disposés dans ce cylindre intérieur 314. Dans l'exemple présent, représenté en figures 3 et 4, les moyens d'adaptation 114 comprennent une lentille collectrice 316 convergente disposée au niveau de l'extrémité proximale du cylindre intérieur 314. Cette lentille 316 permet d'adapter la largeur du rayonnement lumineux 108 à l'entrée de la fibre optique 116.

L'entrée de la fibre optique est également disposée à l'intérieur du cylindre intérieur en aval de la lentille collectrice 316 et centrée très précisément par rapport à l'axe optique de la lentille collectrice 316.

Le cylindre intérieur peut également comprendre tout élément optique nécessaire pour l'étude de l'échantillon par exemple un polariseur.

Le fait que le cylindre intérieur soit libre en rotation permet de modifier l'orientation des différents éléments optiques sans avoir à les retirer.

Ainsi, selon ce premier aspect du système de détection de cathodoluminescence, il est possible d'accéder facilement aux éléments optiques composant les moyens d'adaptation ainsi qu'à l'entrée de la fibre optique pour les changer, les réparer ou les repositionner.

**Deuxième aspect de l'invention**

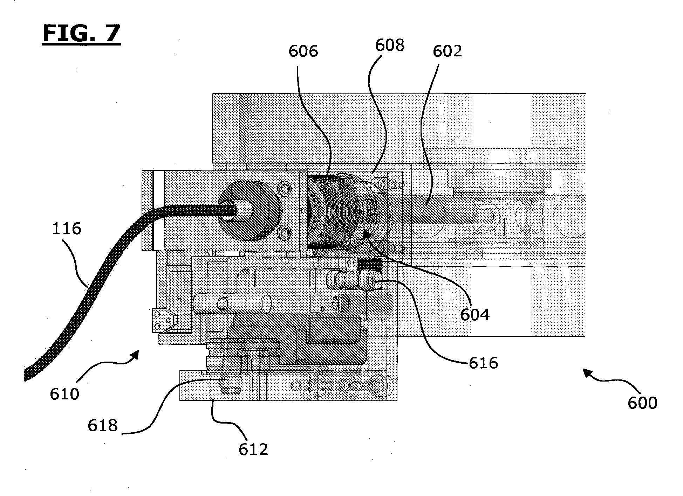

Nous allons maintenant décrire un deuxième aspect de système de cathodoluminescence objet de la présente invention en référence aux figures 6 et 7.

La figure 6 est une représentation partielle vue de dessus d'un microscope mettant en oeuvre un système de détection de cathodoluminescence selon le deuxième aspect de l'invention. Sur la figure 6, l'optique de collection est complètement rétractée, permettant une utilisation standard du microscope. Elle ne correspond pas à une vue du système de détection de cathodoluminescence en fonctionnement. La figure 7 est une représentation du microscope de la figure 6 selon une vue de côté.

L'optique de collection 112 est liée solidairement à un cylindre 602, grâce à deux vis 304 au niveau de l'extrémité proximale 604 du cylindre 602. L'optique de collection 112 est située dans la chambre à vide 302 du microscope 600. Le cylindre 602 peut également comprendre les moyens optiques d'adaptation 114 et de l'entrée de la fibre optique 116 qui peuvent par exemple être disposés dans un deuxième cylindre inséré dans le cylindre 602 de manière démontable, libre en rotation et monté de sorte que l'axe de symétrie se confonde avec l'axe de symétrie du cylindre 602. Le cylindre 602 peut être le cylindre extérieur 306 et comprendre le cylindre intérieur 314, tels que décrits plus haut.

Le cylindre 602 pénètre dans la chambre à vide 302 grâce à une ouverture 604 formée dans une paroi de la chambre à vide. Cette ouverture 604 est disposée en regard du rayonnement lumineux renvoyé par l'optique de collection 112. Le diamètre de cette ouverture est supérieur au diamètre extérieur du cylindre 602 de manière à permettre le déplacement du cylindre extérieur selon les trois dimensions de l'espace. Cette ouverture 604 peut être l'ouverture 308 décrite plus haut.

Un soufflet 606 est fixé au cylindre 602 et entoure le cylindre 602 de manière étanche. Ce soufflet est par ailleurs fixé de manière étanche sur la paroi de la chambre à vide 302, autour de l'ouverture 602, grâce à une pièce de liaison 608 épousant la forme extérieure de la paroi de la chambre à vide autour de l'ouverture 602. Ainsi, la liaison du soufflet 606 avec le cylindre 602 est étanche tout comme la liaison du soufflet 606 avec la paroi de la chambre à vide 302. Le soufflet 606 autorise le déplacement du cylindre 606 dans les trois directions de l'espace tout en préservant à tout moment l'étanchéité au niveau de chacune de ses liaisons avec d'une part le cylindre 602 et d'autre part la paroi de la chambre à vide 302.

Le cylindre 602 comporte une fenêtre d'étanchéité (non représentée sur les figures 6-7). Cette fenêtre d'étanchéité permet de préserver l'étanchéité de la chambre à vide 302. Cette fenêtre d'étanchéité peut être disposée en amont ou en aval des moyens optiques d'adaptation 114 et de l'entrée de la fibre optique 116. Cette fenêtre d'étanchéité peut par exemple être la fenêtre d'étanchéité 312 des figures 3-5 lorsque les deux aspects du système de cathodoluminescence décrits dans la présente demande sont combinés.

Le cylindre 602 est monté solidairement sur un dispositif de déplacement tridimensionnel 610 du côté de son extrémité distale 612, c'est-à-dire son extrémité du côté opposé à l'optique de collection 112. Ce dispositif 610 de déplacement tridimensionnel est posé sur une platine 612 fixée solidairement à la paroi de la chambre à vide. Le dispositif 610 comprend trois vis micrométriques 614, 616 et 618 permettant de déplacer le cylindre 602 selon les trois dimensions de l'espace.

L'optique de collection 112 étant solidaire du cylindre 602, le déplacement du cylindre 602 entraîne le déplacement de l'optique de collection 112. Ainsi, grâce à ce deuxième aspect du système de détection de cathodoluminescence il est possible pour l'opérateur de déplacer l'optique de collection de l'extérieur du microscope pour mieux le positionner par rapport à la source d'émission de d'électrons et par rapport à l'échantillon pour améliorer la conservation de l'intensité du rayonnement lumineux collecté en aval de l'optique de collection ainsi que la résolution spectrale du signal lumineux.

Il est clair pour l'homme du métier, à la lecture de la présente demande, que les premier et deuxième aspects du système de détection de cathodoluminescence peuvent être combinés. Tel qu'indiqué, plus haut, le cylindre 602 représenté sur la figure 6 et 7 peut être remplacé par le cylindre extérieur 306 des figures 3 à 5 comprenant la fenêtre d'étanchéité 312, le cylindre intérieur 314 dans lequel sont disposés les moyens d'adaptation 114 (en particulier la lentille collectrice 316) et l'entrée de la fibre optique 116. En combinant le premier et le deuxième aspect de l'invention, il est possible d'obtenir un système de détection de cathodoluminescence à la fois souple et réglable et permettant d'optimiser l'intensité lumineuse collectée, son transport vers les moyens d'analyse tout en conservant une résolution spectrale optimale par des moyens communs et faciles à mettre en oeuvre.


**Troisième aspect de l'invention**

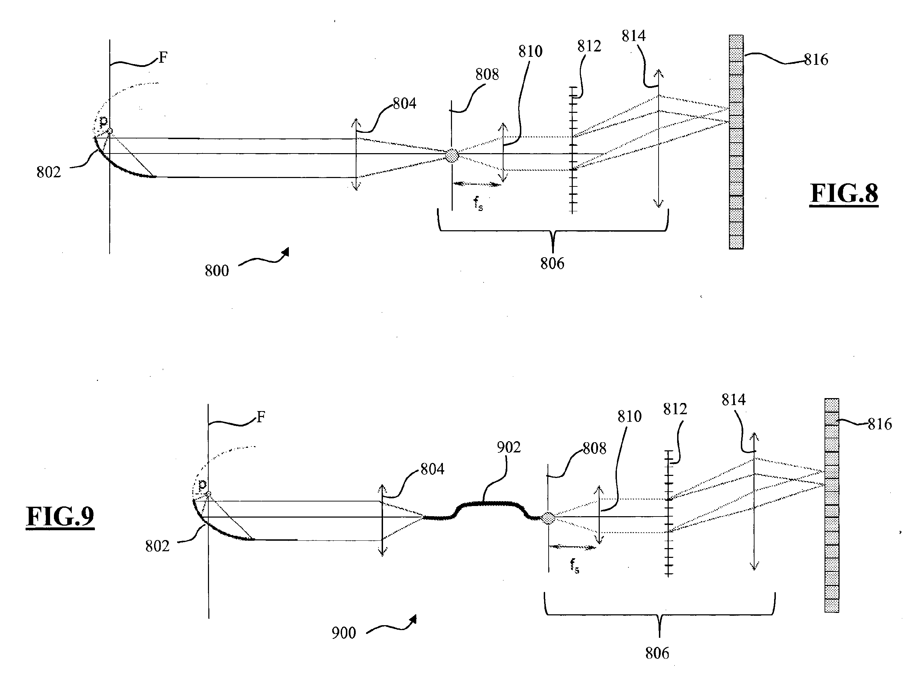

La figure 8 est une représentation schématique d'un premier exemple du chemin optique d'un système de cathodoluminescence selon le troisième aspect de l'invention.

Le chemin optique 800 de la figure 8 comprend en tant que moyen de collection un miroir parabolique 802 qui peut être identique au miroir parabolique 200 de la figure 2 qui collecte le rayonnement lumineux provenant d'un échantillon éclairé par un faisceau de particules.

Le chemin optique 800 comprend en tant que moyen de traitement une lentille 804, qui peut être la lentille 316 des figures 3 et 4, recevant le rayonnement lumineux connecté par le miroir parabolique 802 et l'injectant dans un spectromètre 806 dont l'entrée est symbolisée par le plan 808. Le spectromètre 806 comprend une lentille 810 disposée en amont du réseau 812 du spectromètre 806 et qui renvoie le rayonnement lumineux entrant dans le spectromètre 806 sur le réseau 812 du spectromètre 806. Le spectromètre 806 comprend en outre une lentille 814 disposée en aval du réseau 812 du spectromètre 806 qui symbolise la sortie du spectromètre et qui renvoie le rayonnement lumineux sortant du spectromètre 806 vers une caméra CCD 816. Le spectromètre 806 et la caméra 816 constitue les moyens d'analyse du système de cathodoluminescence.

Selon le troisième aspect de l'invention, le miroir parabolique, la lentille 804, le spectromètre 806 sont choisis et positionnés tels que :

- le miroir parabolique 802 présente une valeur p de 2 mm et une épaisseur de 3 mm;
- l'angle maximal de sortie du miroir parabolique 802 soit de zéro (faisceau parallèle) et l'angle maximal d'entrée de la lentille 804 soit de zéro (faisceau parallèle) ;
- le profil du rayonnement provenant du miroir parabolique 802 dans le plan d'entrée de la lentille 804 soit de 9 mm sur 3 mm et le diamètre utile en entrée de la lentille 802 soit de 8 mm ;
- en considérant le centre du miroir parabolique comme étant le point milieu entre ses surfaces horizontales et verticales (parallèles à l'axe optique de la lentille), le décalage de la lentille 804 par rapport au centre du miroir parabolique, soit inférieur à 100 microns. La position du foyer du miroir est dans ces conditions calculée pour obtenir le maximum d'angle de collection pour le miroir ; et

- l'angle maximal de sortie de la lentille 804 soit de 6.3.

Par ailleurs :

- la largeur du faisceau à l'entrée dudit spectromètre dans la direction dispersive est de typiquement 100 ou 70 microns et le diamètre limite à l'entrée du spectromètre en dessous duquel la résolution du spectromètre ne dépend plus du diamètre de la taille du rayonnement lumineux à l'entrée du spectromètre est de 70 $\mu$m.

En outre :

- la précision du déplacement dans au moins une des deux directions de l'espace perpendiculaire à l'axe optique et dans la direction de l'axe optique est meilleure que ou égale à 1 $\mu$m assurant une résolution à l'entrée du spectromètre meilleure que 30 microns, c'est-à-dire inférieure à la taille limite à l'entrée du spectromètre en dessous de laquelle la résolution est dégradée.

La figure 9 est une représentation schématique d'un deuxième exemple du chemin optique d'un système de cathodoluminescence selon le troisième aspect de l'invention.
Le chemin optique 900 de la figure 9 comprend tous les éléments du chemin optique 800 représenté en figure 8.
Le chemin optique 900 comprend en outre une fibre optique 902, qui peut être la fibre optique 116 des figures 3 et 4. L'entrée de la fibre optique 902 est positionnée au point focal de la lentille 804 et la sortie de la fibre optique est positionnée dans le plan d'entrée du spectromètre 806 matérialisée par le plan 808.
Les paramètres des éléments optiques dans le chemin optique 900 restent identiques aux paramètres donnés en référence à la figure 1.
Cependant :

- la largeur du rayonnement à l'entrée de la fibre optique 902 est, dans le cas ou l'objet étudié est infiniment petit, de l'ordre de 15 microns et le diamètre utile en entrée de la fibre optique est de 70 $\mu$m ;
- l'angle maximal du rayonnement provenant de la lentille 804 est de 6.3° et l'angle limite d'incidence en entrée de la fibre optique 902 est de 6.9° ; et
- le décalage de la fibre 902 par rapport au centre de la lentille est inférieur à 100 microns.

Par ailleurs,

- la largeur du faisceau à l'entrée dudit spectromètre dans la direction dispersive est de 70 $\mu$m et le diamètre limite à l'entrée du spectromètre en dessous duquel la résolution du spectromètre ne dépend plus du diamètre de la taille du rayonnement lumineux à l'entrée du spectromètre est de 70 $\mu$m.

En outre :

- la précision du déplacement dans au moins une des deux directions de l'espace perpendiculaire à l'axe optique et dans la direction de l'axe optique est meilleure que 1$\mu$m assurant une résolution à l'entrée de la fibre optique meilleure que 30 microns, c'est-à-dire inférieure à la taille limite à l'entrée du spectromètre en dessous de laquelle la résolution est dégradée ; et
- le diamètre de chaque fibre optique divisé par le grandissement réalisé sur le chemin optique jusqu'au faisceau de fibre optiques 1002 est de 2 $\mu$m.

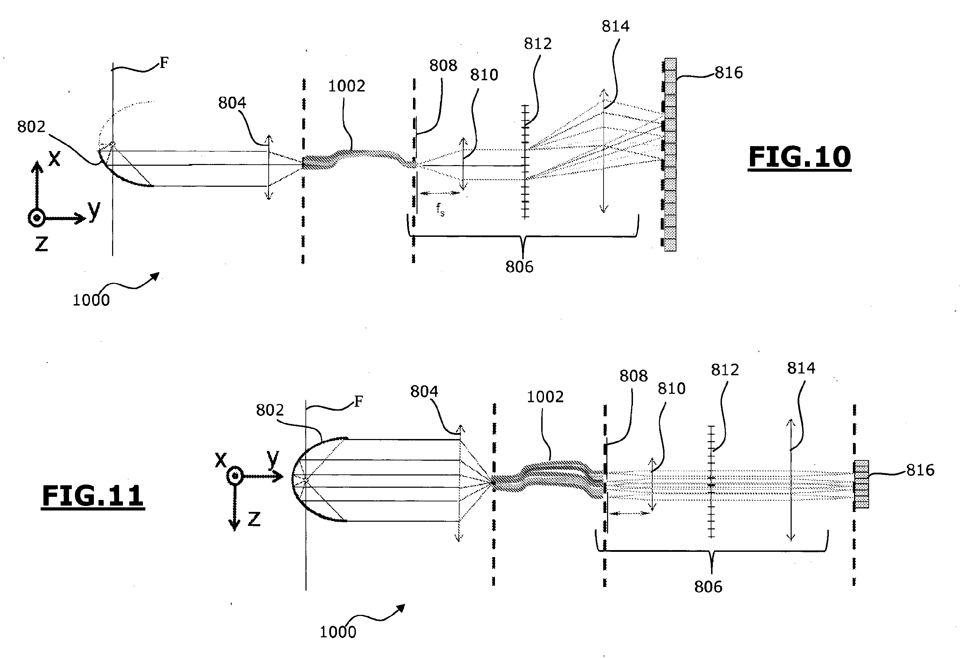

Les Figures 10 et 11 sont des représentations schématiques selon différentes vues d'un troisième exemple du chemin optique d'un système de cathodoluminescence selon le troisième aspect de l'invention comprenant un faisceau de fibres optiques.
Le chemin optique 1000 des figures 10 et 11 comprend tous les éléments du chemin optique 800 représenté en figure 8.
Le chemin optique 1000 comprend en outre un faisceau de fibres optiques 1002, composées par exemple de plusieurs fibres optiques telles que la fibre optique 902 de la figure 9. L'entrée du faisceau de fibres optiques 1002 est positionnée au point focal de la lentille 804 et la sortie du faisceau de fibres optiques est positionnée dans le plan d'entrée du spectromètre 806 matérialisée par le plan 808.
Les paramètres des éléments optiques dans le chemin optique 1000 restent identiques aux paramètres donnés en référence à la figure 1.
Cependant:

- la largeur du rayonnement à l'entrée du faisceau de fibre optique 1002 est supérieure ou égale à 200 microns et le diamètre utile en entrée de chaque fibre optique composant le faisceau de fibres optiques 1002 est de 70 $\mu$m ;
- l'angle d'entrée maximum du rayonnement provenant de la lentille 804 est de 6.3° et l'angle limite d'incidence en entrée dans chaque fibre optique composant le faisceau de fibre optique 1002 est de 6.9° ; et
- le décalage du faisceau de fibres optiques 1002 par rapport au centre de la lentille est de de l'ordre de la centaine de microns.

Par ailleurs,

- la largeur du faisceau à l'entrée dudit spectromètre dans la direction dispersive est de 70 $\mu$m, et le diamètre limite à l'entrée du spectromètre en dessous duquel la résolution du spectromètre ne dépend plus du diamètre de la taille du rayonnement lumineux à l'entrée du spectromètre est de 70 $\mu$m.

En outre :

- la précision du déplacement dans au moins une des deux directions de l'espace perpendiculaire à l'axe optique et dans la direction de l'axe optique est de 1 $\mu$m ou meilleure que 1 $\mu$m assurant une résolution à l'entrée de la fibre optique meilleure que 30 microns, c'est-à-dire inférieure à la taille limite à l'entrée du spectromètre en dessous de laquelle la résolution est dégradée ; et
- le diamètre de chaque fibre optique divisé par le grandissement réalisé sur le chemin optique jusqu'au faisceau de fibre optiques 1002 est de 2 $\mu$m.

Selon l'invention chacun de ces trois exemples de réalisation permet de véhiculer le rayonnement lumineux émis par l'échantillon jusqu'à la caméra CCD tout en conservant plus d'intensité de lumineux, une résolution spectrale optimale et la possibilité d'utiliser l'invention dans un microscope à particules chargées capables de former des sondes de tailles nanométriques voire angströmiques.

Par ailleurs, le troisième exemple représenté sur les figures 10 et 11 permet également de corriger les erreurs dynamiques, systématiques ou des erreurs dues à un balayage de l'échantillon.

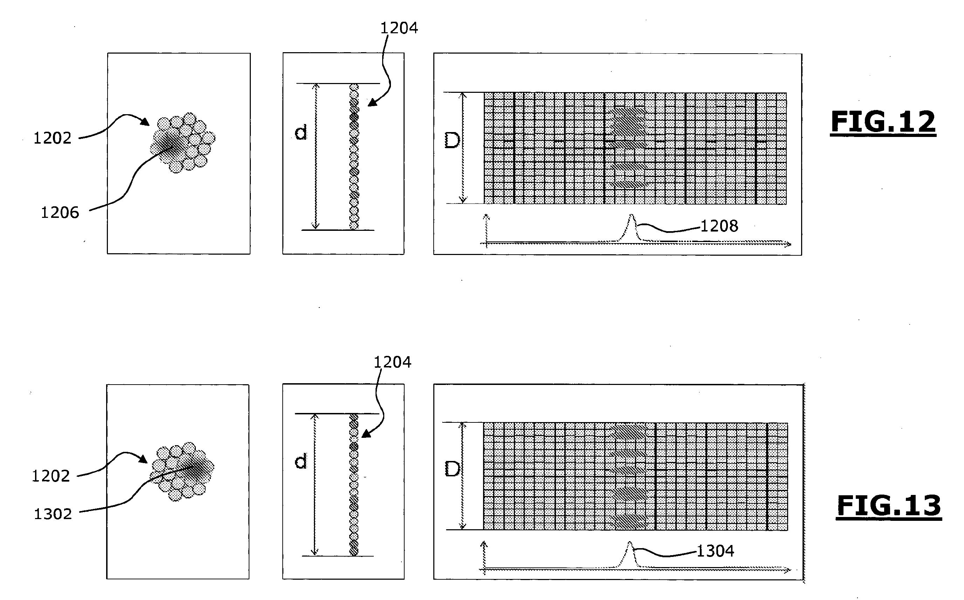

Pour cela, à l'entrée 1202 du faisceau 1002, les fibres optiques composant le faisceau 1002 sont disposées de manière circulaire ou hexagonale, les unes autour des autres. A la sortie 1204 du faisceau 1002, les fibres optiques composant le faisceau 1002 sont alignées, les unes sur les autres, dans une direction perpendiculaire à la direction de dispersion du spectromètre. L'entrée 1202 et la sortie 1204 du faisceau de fibres optiques 1002 sont représentées de manière schématique sur les figures 12 et 13.

Les figures 12 et 13 qui sont des représentations schématiques de deux configurations dans lesquelles le rayonnement lumineux arrive à l'entrée du faisceau de fibres optiques en deux positions différentes dans le système des figures 10 et 11. Dans la configuration représentée en figure 12, le rayonnement lumineux atteint l'entrée 1202 du faisceau 1002 de fibres optiques en un point 1206 décalé vers la gauche par rapport à son centre et dans la configuration représentée en figure 13, le rayonnement lumineux atteint l'entrée 1202 du faisceau 1002 de fibres optiques en un point 1302 décalé vers la droite par rapport à son centre. En fonction des fibres concernées, le rayonnement lumineux entrant dans le faisceau 1002 de fibres optiques ne sort pas du faisceau 1002 de fibres optiques aux mêmes positions. Cependant, dans les deux cas et malgré la différence de position du rayonnement lumineux arrivant dans le plan d'entrée du faisceau 1002 de fibres optiques, l'ensemble du rayonnement est capté et véhiculé jusqu'au spectromètre par le faisceau 1002 de fibres optiques et les spectres 1208 et 1304 obtenus au niveau de la caméra CCD pour chacun des deux rayonnements sont identiques. Ceci se fait sans perte de résolution spectrale ni d'intensité.

Les trois aspects de la présente invention peuvent être combinés, deux à deux ou les trois sur un unique système de cathodoluminescence.

Bien sûr, l'invention n'est pas limitée aux exemples qui viennent d'être décrits et de nombreux aménagements peuvent être apportés à ces exemples sans sortir du cadre de l'invention.

**Revendications**

1. Système (110) de détection de cathodoluminescence comprenant :

   - une optique de collection (112) collectant un rayonnement lumineux (108) provenant d'un échantillon (106) éclairé par un faisceau de particules chargées (104) et renvoyant ledit rayonnement (108) vers des moyens d'analyse (118), ladite optique de collection (112) étant disposée dans une chambre (302), dite chambre à vide, où règne une pression inférieure à la pression atmosphérique,

- des moyens d'adaptation (114, 316) du rayonnement lumineux disposés en aval de l'optique de collection (112) et prévus pour adapter ledit rayonnement lumineux (108) à l'entrée des moyens d'analyse (118), tout ou partie des moyens d'adaptation (114, 316) étant disposés dans un environnement où règne une pression supérieure à la pression dans ladite chambre à vide (302), et

- un tube (306, 602) en forme de cylindre, dit cylindre extérieur, aligné par rapport à l'axe de l'optique de collection et solidaire de ladite optique de collection (112), ledit cylindre extérieur (306, 602) comprenant une fenêtre d'étanchéité (312) assurant le maintien de la pression de la chambre à vide dans laquelle est disposée ladite optique de collection (112),

un tube (314) en forme de cylindre, dit cylindre intérieur, **caractérisé en ce que** le tube (314) est disposé centré dans le cylindre extérieur (306, 602) en aval de ladite fenêtre d'étanchéité (312), et prévu pour recevoir les moyens d'adaptation (316) du rayonnement lumineux (108) en vue d'injecter ledit rayonnement lumineux (108) dans une fibre optique (116) ou dans un détecteur.

2.  Système selon la revendication 1, **caractérisé en ce qu'**il comprend des moyens d'étanchéité (310, 312, 606) disposés entre ladite optique de collection (112) et les moyens d'adaptation (114, 316) et prévus pour assurer l'étanchéité de ladite chambre à vide (302) tout en autorisant le passage du rayonnement lumineux (108).

3.  Système selon l'une quelconque des revendications précédentes, **caractérisé en ce que** les moyens d'adaptation comprennent au moins une lentille (316) disposée en amont d'une fibre optique (116) et prévue pour renvoyer le rayonnement lumineux (108) dans ladite fibre optique (116).

4.  Système selon l'une quelconque des revendications précédentes, **caractérisé en ce que** l'optique de collection comprend un miroir parabolique (112, 202).

5.  Système selon l'une quelconque des revendications 1 à 3, **caractérisé en ce que** l'optique de collection comprend un miroir plan ou un miroir elliptique associé à au moins une lentille optique.

6.  Système selon l'une quelconque des revendications précédentes, **caractérisé en ce que** le cylindre intérieur (314) est monté démontable dans le cylindre extérieur (306, 602) et libre en rotation par rapport audit cylindre extérieur (306, 602).

7.  Système selon l'une quelconque des revendications précédentes, **caractérisé en ce que** les moyens d'adaptation (316) sont agencés pour adapter l'angle et la taille du rayonnement lumineux (108) collecté à la taille et à l'ouverture numérique d'un détecteur ou d'une fibre optique (116).

8.  Système selon l'une quelconque des revendications précédentes, **caractérisé en ce que** les moyens d'adaptation (316) comprennent un diaphragme arrangé pour laisser passer le rayonnement lumineux provenant de l'optique de collection (112) vers les moyens d'analyse et bloquer au moins un signal optique indésirable.

9.  Système selon l'une quelconque des revendications précédentes, **caractérisé en ce qu'**il comprend une source d'émission d'un faisceau lumineux se propageant dans le sens inverse du sens de propagation du rayonnement lumineux, ledit faisceau lumineux étant dirigé vers l'échantillon (106) par l'optique de collection (112).

10. Système selon l'une quelconque des revendications précédentes, **caractérisé en ce qu'**il comprend en outre des moyens d'analyse (118) du rayonnement lumineux (108), disposés en aval des moyens d'adaptation (114, 316).

11. Système selon la revendication 10, **caractérisé en ce que** les moyens d'analyse (118) comprennent un spectromètre, une caméra CCD ou un photomultiplicateur.

12. Système selon l'une quelconque des revendications précédentes, **caractérisé en ce que** l'optique de collection (112) est montée déplaçable sur au moins une dimension, ledit système comprenant en outre des moyens de positionnement (614-618) prévus pour déplacer ladite optique de collection (112) selon au moins une dimension.

13. Système selon la revendication 12, **caractérisé en ce que** les moyens de positionnement comprennent une platine (612) montée déplaçable sur au moins une dimension, l'optique de collection (112) étant montée solidaire de ladite platine, ledit système comprenant en outre au moins un élément de positionnement prévu pour déplacer ladite platine selon au moins une dimension.

**14.** Microscope (100, 600) comprenant :

- une source d'émission (102) d'un faisceau de particules chargées (104), et
- un système (110) de détection de cathodoluminescence selon l'une quelconque des revendications précédentes.

**15.** Microscope (100, 600) selon la revendication 14, **caractérisé en ce qu'**il comprend en outre au moins :

- un détecteur fond clair (126),
- un détecteur fond noir (128),
- un détecteur EELS (130),
- une caméra pour l'imagerie ou la diffraction, ou
- un détecteur EDX.

**Patentansprüche**

**1.** System (110) zur Detektion von Kathodolumineszenz, umfassend:

- eine Sammeloptik (112), die eine Lichtstrahlung (108), welche von einer mit einem Strahl geladener Teilchen (104) bestrahlten Probe (106) kommt, sammelt und die Strahlung (108) zu Analysemitteln (118) lenkt, wobei die Sammeloptik (112) in einer Kammer (302), sogenannten Vakuumkammer, angeordnet ist, in der ein Druck herrscht, der unterhalb des atmosphärischen Druckes liegt,
- Mittel zur Anpassung (114, 316) der Lichtstrahlung, die der Sammeloptik (112) nachgeschaltet sind und dazu vorgesehen sind, die Lichtstrahlung (108) an den Eingang der Analysemittel (118) anzupassen, wobei alle Anpassungsmittel (114, 316) oder ein Teil davon in einer Umgebung angeordnet sind, in der ein Druck herrscht, der oberhalb des Druckes in der Vakuumkammer (302) liegt, und
- eine zylinderförmige Röhre (306, 602), sogenannter Außenzylinder, die gegenüber der Achse der Sammeloptik ausgerichtet ist und mit der Sammeloptik (112) fest verbunden ist, wobei der Außenzylinder (306, 602) ein Dichtungsfenster (312) umfasst, das das Halten des Druckes der Vakuumkammer, in der die Sammeloptik (112) angeordnet ist, sicherstellt,
- eine zylinderförmige Röhre (314), sogenannter Innenzylinder,

**dadurch gekennzeichnet, dass** die Röhre (314) in dem Außenzylinder (306, 602) nach dem Dichtungsfenster (312) zentriert angeordnet ist und dazu vorgesehen ist, die Mittel zur Anpassung (316) der Lichtstrahlung (108) aufzunehmen, um die Lichtstrahlung (108) in einen Lichtwellenleiter (116) oder in einen Detektor einzuspeisen.

**2.** System nach Anspruch 1, **dadurch gekennzeichnet, dass** es Dichtungsmittel (310, 312, 606) umfasst, die zwischen der Sammeloptik (112) und den Anpassungsmitteln (114, 316) angeordnet sind und dazu vorgesehen sind, die Dichtigkeit der Vakuumkammer (302) zu gewährleisten und gleichzeitig den Durchgang der Lichtstrahlung (108) zuzulassen.

**3.** System nach einem der vorhergehenden Ansprüche, **dadurch gekennzeichnet, dass** die Anpassungsmittel wenigstens eine Linse (316) umfassen, die einem Lichtwellenleiter (116) vorgeschaltet ist und dazu vorgesehen ist, die Lichtstrahlung (108) in den Lichtwellenleiter (116) zu lenken.

**4.** System nach einem der vorhergehenden Ansprüche, **dadurch gekennzeichnet, dass** die Sammeloptik einen Parabolspiegel (112, 202) umfasst.

**5.** System nach einem der Ansprüche 1 bis 3, **dadurch gekennzeichnet, dass** die Sammeloptik einen Planspiegel oder einen elliptischen Spiegel, der wenigstens einer optischen Linse zugeordnet ist, umfasst.

**6.** System nach einem der vorhergehenden Ansprüche, **dadurch gekennzeichnet, dass** der Innenzylinder (314) in dem Außenzylinder (306, 602) demontierbar und gegenüber dem Außenzylinder (306, 602) drehfrei angebracht ist.

**7.** System nach einem der vorhergehenden Ansprüche, **dadurch gekennzeichnet, dass** die Anpassungsmittel (316) dazu ausgelegt sind, den Winkel und die Größe der gesammelten Lichtstrahlung (108) an die Größe und an die numerische Apertur eines Detektors oder eines Lichtwellenleiters (116) anzupassen.

8. System nach einem der vorhergehenden Ansprüche, **dadurch gekennzeichnet, dass** die Anpassungsmittel (316) eine Blende umfassen, die angeordnet ist, um die von der Sammeloptik (112) kommende Lichtstrahlung zu den Analysemitteln passieren zu lassen und wenigstens ein unerwünschtes optisches Signal zu blockieren.

9. System nach einem der vorhergehenden Ansprüche, **dadurch gekennzeichnet, dass** es eine Quelle zum Aussenden eines Lichtstrahls, der sich in der Gegenrichtung der Fortpflanzungsrichtung der Lichtstrahlung fortpflanzt, umfasst, wobei der Lichtstrahl durch die Sammeloptik (112) in Richtung der Probe (106) gerichtet wird.

10. System nach einem der vorhergehenden Ansprüche, **dadurch gekennzeichnet, dass** es ferner Mittel zur Analyse (118) der Lichtstrahlung (108) umfasst, die den Anpassungsmitteln (114, 316) nachgeschaltet sind.

11. System nach Anspruch 10, **dadurch gekennzeichnet, dass** die Analysemittel (118) ein Spektrometer, eine CCD-Kamera oder einen Photomultiplier umfassen.

12. System nach einem der vorhergehenden Ansprüche, **dadurch gekennzeichnet, dass** die Sammeloptik (112) über wenigstens eine Dimension beweglich angebracht ist, wobei das System ferner Positionierungsmittel (614-618) umfasst, die dazu vorgesehen sind, die Sammeloptik (112) entlang wenigstens einer Dimension zu bewegen.

13. System nach Anspruch 12, **dadurch gekennzeichnet, dass** die Positionierungsmittel eine Platte (612) umfassen, die über wenigstens eine Dimension beweglich angebracht ist, wobei die Sammeloptik (112) mit der Platte fest verbunden angebracht ist, wobei das System ferner wenigstens ein Positionierungselement umfasst, das dazu vorgesehen ist, die Platte entlang wenigstens einer Dimension zu bewegen.

14. Mikroskop (100, 600), umfassend:

   - eine Quelle zum Aussenden (102) eines Strahls geladener Teilchen (104) und
   - ein System (110) zur Detektion von Kathodolumineszenz nach einem der vorhergehenden Ansprüche.

15. Mikroskop (100, 600) nach Anspruch 14, **dadurch gekennzeichnet, dass** es ferner wenigstens umfasst:

   - einen Hellfelddetektor (126),
   - einen Dunkelfelddetektor (128),
   - einen EELS-Detektor (130),
   - eine Kamera für die Bildgebung oder die Beugung oder
   - einen EDX-Detektor.

**Claims**

1. A cathodoluminescence detection system (110) comprising:

   - a collection optic (112) collecting light radiation (108) coming from a sample (106) illuminated by a charged particle beam (104) and sending said radiation (108) to analysis means (118), said collection optic (112) being arranged in a chamber (302), called vacuum chamber, in which the pressure is below atmospheric pressure,
   - means (114, 316) of adjusting the light radiation arranged downstream of the collection optic (112) and capable of adjusting said light radiation (108) at the input of the analysis means (118), all or part of the adjustment means (114, 316) being arranged in an environment in which the pressure is greater than the pressure in said vacuum chamber (302), and
   - a tube (306, 602) in the form of a cylinder, called outer cylinder, aligned relative to the axis of the collection optic and integral with said collection optic (112), said outer cylinder (306, 602) comprising a window seal (312) ensuring that the pressure is maintained in the vacuum chamber in which said collection optic (112) is arranged;
   - a tube (314) in the form of a cylinder, called inner cylinder,

   **characterised in that** the tube (314) is arranged centred in the outer cylinder (306, 602) downstream of the window seal (312), and capable of receiving the means (316) of adjusting the light radiation (108) with a view to injecting said light radiation (108) into an optical fibre (116) or into a detector.

2. The system according to claim 1, **characterised in that** it comprises sealing means (310, 312, 606) arranged between said collection optic (112) and the adjustment means (114, 316) and capable of ensuring the leaktightness of said vacuum chamber (302) while permitting the light radiation (108) to pass through.

3. The system according to any one of the previous claims, **characterised in that** the adjustment means comprise at least one lens (316) arranged upstream of an optical fibre (116) and capable of sending the light radiation (108) into said optical fibre (116).

4. The system according to any one of the previous claims, **characterised in that** the collection optic comprises a parabolic mirror (112, 202).

5. The system according to any one of claims 1 to 3, **characterised in that** the collection optic comprises a plane mirror or an elliptical mirror associated with at least one optical lens.

6. The system according to any one of the previous claims, **characterised in that** the inner cylinder (314) is mounted removably in the outer cylinder (306, 602) and can rotate freely relative to said outer cylinder (306, 602).

7. The system according to any one of the previous claims, **characterised in that** the adjustment means (316) are arranged to adjust the angle and size of the light radiation (108) collected to the size and numerical aperture of a detector or an optical fibre (116).

8. The system according to any one of the previous claims, **characterised in that** the adjustment means (316) comprise a diaphragm arranged to let the light radiation coming from the collection optic (112) through to the analysis means and block at least one undesirable optical signal.

9. The system according to any one of the previous claims, **characterised in that** it comprises a source of emission of a light beam propagating in the opposite direction to the direction of propagation of the light radiation, said light beam being directed towards the sample (106) by the collection optic (112).

10. The system according to any one of the previous claims, **characterised in that** it also comprises means (118) of analysing the light radiation (108), arranged downstream of the adjustment means (114, 316).

11. The system according to claim 10, **characterised in that** the analysis means (118) comprise a spectrometer, a CCD camera or a photomultiplier.

12. The system according to any one of the previous claims, **characterised in that** the collection optic (112) is mounted movably in at least one dimension, said system also comprising positioning means (614-618) capable of moving said collection optic (112) in at least one dimension.

13. The system according to claim 12, **characterised in that** the positioning means comprise a stage (612) mounted movably in at least one dimension, the collection optic (112) being securely mounted on said stage, said system also comprising at least one positioning component capable of moving said stage in at least one dimension.

14. A microscope (100, 600) comprising:

   - a source (102) of emission of a charged particle beam (104), and
   - a cathodoluminescence detection system (110) according to any one of the previous claims.

15. The microscope (100, 600) according to claim 14, **characterised in that** it also comprises at least:

   - one bright field detector (126),
   - one dark field detector (128),
   - one EELS detector (130),
   - one camera for imaging or diffraction, or
   - one EDX detector.

**FIG. 1**

**FIG. 2**

**FIG. 3**

**FIG. 4**

**FIG. 5**

**FIG. 6**

**FIG. 7**

**FIG.8**

**FIG.9**

**FIG.10**

**FIG.11**

**FIG.12**

**FIG.13**

EP 2 577 706 B1

## RÉFÉRENCES CITÉES DANS LA DESCRIPTION

**Documents brevets cités dans la description**

- US 7589322 B

- US 2003053048 A1